# FASCICULE DE BREVET EUROPEEN

(11) **EP 2 213 616 B1**
(45) Date de publication et mention de la délivrance du brevet: **20.07.2011**
(21) Numéro de dépôt: 10151594.8
(22) Date de dépôt: 25.01.2010
(51) Int. Cl.: B81C 1/00, G01P 1/02, H01L 23/10

(54) **Procédé de fermeture de cavité pour au moins un dispositif microélectronique**
Verfahren zum Verschließen eines Hohlraums für mindestens eine mikroelektronische Vorrichtung
Method for closing a cavity for at least one microelectronic device

(30) Priorité: 28.01.2009 FR 0950494
(43) Date de publication de la demande: 04.08.2010
(73) Titulaire: Commissariat à l'Énergie Atomique et aux Énergies Alternatives, 75015 Paris (FR)
(72) Inventeur: Delapierre, Gilles, 38180, SEYSSINS (FR); Diem, Bernard, 38130, ECHIROLLES (FR); Perruchot, Francois, 38000, GRENOBLE (FR)
(74) Mandataire: Ilgart, Jean-Christophe

(56) Documents cités:
- EP-A- 1 834 924
- DE-A1-102005 060 870
- FR-A- 2 870 227
- US-A1- 2007 235 501

## Description

### DOMAINE TECHNIQUE

L'invention concerne le domaine des dispositifs microélectroniques, ou puces, tels que des microsystèmes électromécaniques (MEMS) et/ou des nanosystèmes électromécaniques (NEMS). L'invention concerne notamment un procédé d'encapsulation collective de plusieurs dispositifs de type MEMS ou NEMS réalisés sur un même substrat.

### ÉTAT DE LA TECHNIQUE ANTÉRIEURE

Afin de réduire le coût de réalisation des dispositifs microélectroniques de type MEMS, il est utile de réduire la taille des dispositifs pour en avoir le plus grand nombre possible sur un même substrat, et donc d'en réduire le coût. Il est également utile d'utiliser des procédés de fabrication collectifs pour la fabrication de ces dispositifs, en y incluant notamment une étape d'encapsulation qui est très coûteuse si elle est réalisée individuellement pour chaque dispositif après découpe du substrat. L'étape d'encapsulation consiste à sceller un capot au-dessus d'un ou plusieurs dispositifs microélectroniques afin qu'ils soient isolés de l'environnement extérieur dans une cavité.

Un des moyens pour préserver les performances d'un dispositif microélectronique malgré sa miniaturisation est de contrôler toujours plus finement l'atmosphère dans laquelle est disposé le dispositif. Un tel dispositif microélectronique de type MEMS est un objet mécanique en mouvement dont les propriétés sont très dépendantes de l'atmosphère environnante. En particulier, le bruit thermomécanique des masses suspendues que peut présenter un dispositif est directement lié au facteur de qualité de ce dispositif et donc à l'amortissement réalisé par le gaz présent dans la cavité dans laquelle se trouve le dispositif. Un faible amortissement peut par exemple être obtenu par un vide le plus poussé possible. Dans d'autres cas, un fort amortissement peut être intéressant pour limiter la bande passante du dispositif et réduire sa sensibilité aux chocs. Ce fort amortissement peut être obtenu par une pression environnante du dispositif aux environs de la pression atmosphérique. L'atmosphère souhaitée dans la cavité dans laquelle se trouve le dispositif peut donc aller d'un vide très poussé pour avoir un bruit faible et des pics de résonances très étroits, à plusieurs bars pour avoir un fort amortissement et une diminution des fréquences de coupure.

Il est possible de réaliser l'encapsulation d'un dispositif de type MEMS en mettant en oeuvre une seule étape qui assure à la fois le scellement du capot et le contrôle de la pression à l'intérieur de la cavité. Une telle encapsulation implique toutefois de fortes contraintes pour assurer la compatibilité de ces deux fonctions car dans ce cas, il est nécessaire que le dispositif soit libéré avant l'étape de scellement et que l'opération de scellement soit compatible avec l'environnement souhaité pour le dispositif (vide ou atmosphère particulière). Ces contraintes sont très limitantes et réduisent le nombre de techniques pouvant être utilisées.

L'encapsulation d'un dispositif de type MEMS peut également être mise en oeuvre en deux étapes : protection du dispositif par scellement du capot en conservant de petites ouvertures, généralement sous forme de trous ou de tranchées, puis fermeture de ces ouvertures en atmosphère contrôlée. Dans ce cas, le scellement du capot peut s'effectuer avant la libération du dispositif. La liberté sur les conditions de préparation des surfaces est ainsi grandement améliorée. La libération du dispositif s'effectue après le scellement du capot, par attaque chimique à travers les ouvertures préservées à cet effet. Le scellement peut aussi être effectué après libération, les conditions d'atmosphère et de température pendant l'opération de scellement étant alors choisies de façon optimale. L'encapsulation se déroule dans ce cas en deux étapes principales :
- report d'un substrat de capotage ou dépôt d'une couche mince pour créer la cavité, ce substrat ou cette couche comportant des ouvertures,
- bouchage des ouvertures dans un environnement correspondant à celui souhaité dans la cavité (pression et/ou gaz particuliers).

La séparation des fonctions de capotage et de fermeture de la cavité permet d'effectuer le scellement du capot avec peu de restrictions sur l'atmosphère ambiante.

Le report du substrat peut être réalisé par différents types de scellement : par cordon de verre fusible, par couche mince eutectique Au-Si, par collage direct Si/SiO2, ou encore par soudure anodique (« anodic bonding ») de verre sur silicium (application simultanée d'une haute tension et d'une haute température). Ces scellements sont généralement réalisés à une température comprise entre environ 200°C et 1000°C, et le plus couramment aux environs de 400°C.

Une alternative au report d'un substrat consiste à déposer une couche mince sur une couche dite sacrificielle qui enrobe la partie active de la puce. Cette couche sacrificielle est ensuite gravée par attaque chimique à travers un trou. La partie laissée vide par la couche sacrificielle forme la cavité.

Il reste ensuite à boucher le trou en soumettant la cavité à la pression désirée. Plusieurs types de bouchage peuvent être mis en oeuvre.

Pour cela, il est possible de réaliser un report d'un autre substrat sur le capot, avec comme inconvénients le coût du substrat additionnel, la température élevée du scellement et la nécessité d'un polissage de très bonne qualité. Cette technique est réservée au cas où le capot est lui-même un substrat de silicium. Cette technique présente également l'inconvénient d'ajouter une épaisseur supplémentaire (correspondant à celle du substrat reporté) au dispositif et donc d'augmenter son encombrement.

Il est également possible de réaliser le bouchage par un dépôt d'une couche mince, par exemple à base de nitrure de silicium ou de silicium polycristallin, sur le capot, afin d'obstruer progressivement le trou. Le bouchage s'effectue alors au cours du dépôt de la couche mince, lorsque l'épaisseur devient suffisante. Cette technique est toutefois limitée aux trous de très petits diamètres (quelques µm) et ne peut concerner que des dispositifs MEMS pouvant accepter une pression de cavité égale à la pression dans la chambre de dépôt. Ceci est extrêmement limitant et ne concerne que des dispositifs MEMS utilisant des pressions de quelques millibars. Cette technique est de plus difficilement utilisable pour les capots de type substrat reporté car il n'y a pas de surface de dépôt en fond de trou proche de la surface du trou, le temps de dépôt avant bouchage du trou devenant alors très long.

Il est également possible de réaliser le bouchage par un dépôt d'une couche minérale fusible (généralement de type verre PSG, BPSG...) en périphérie du trou, puis de réaliser un refluage à haute température de cette couche pour boucher le trou par un coulage pâteux vers le centre du trou. Cette technique permet d'envisager des pressions de cavité variées (celle au moment du refluage), mais nécessite cependant une haute température de fusion de la couche minérale, de l'ordre de 900°C, ce qui est incompatible avec de nombreux dispositifs MEMS, notamment ceux intégrant un circuit CMOS. De plus, la cavité se bouche alors que le dispositif est à haute température et donc en phase de dégazage, ce qui permet difficilement d'obtenir des vides très poussés.

Selon une autre technique de bouchage, il est possible de réaliser le dépôt d'une couche métallique à bas point de fusion (typiquement à base d'étain/plomb ou d'or/étain) autour du trou et de mettre en fusion le métal déposé avec l'espoir que, grâce à l'effet de capillarité, il va se rassembler en une seule goute au dessus du trou et le refermer. Cette technique peut permettre d'obtenir des pressions variées à relativement basse température dans les cavités. Un inconvénient majeur est cependant qu'il faut déposer une couche assez épaisse de métal fusible pour que la goutte ait une chance de boucher le trou. Ceci est obtenu par des méthodes de dépôt électrolytique en milieu liquide, ce qui dans la plupart des cas n'est pas acceptable par le dispositif MEMS déjà libéré, qui ne doit pas être pollué par les divers agents chimiques de la solution électrolytique. Le métal autour du trou doit de plus avoir une forme de cordon, ce qui suppose l'utilisation de résines photosensibles pour définir cette forme, technologie à nouveau peu compatible avec la présence de trous sur le capot. Autre limitation forte, cette technique ne fonctionne pas pour des ouvertures en forme de tranchée car le métal fondu aura dans ce cas tendance à se rassembler le long du cordon plutôt qu'au dessus de la tranchée. Même dans le cas d'un trou cylindrique, il faudra qu'il soit de très petites dimensions pour que le bouchage se réalise.

Enfin, il est également possible de réaliser le dépôt manuel de billes de métal fusible sur le trou et de mettre en fusion ces billes qui se soudent alors à un cordon métallique préalablement déposé et gravé autour du trou. Cette solution élimine l'inconvénient de la pénétration de liquide dans la cavité du dispositif. Il présente cependant l'inconvénient d'utiliser des opérations manuelles et non collectives lorsque l'on souhaite boucher les trous de capots de plusieurs dispositifs, ce qui est contraire à l'objectif d'utilisation des microtechnologies pour la réduction des coûts. Cette technique est également inadaptée au bouchage de tranchées.

Le document EP 1 834 924 A2 décrit un procédé de fermeture d'une cavité pour un dispositif microélectronique, dans lequel une métallisation est tout d'abord déposée autour d'une ouverture traversant un capot et formant un accès à la cavité, l'ouverture étant ensuite bouchée en faisant fondre une bille de matériau fusible en contact avec la métallisation.

### EXPOSÉ DE L'INVENTION

Un but de la présente invention est de proposer un procédé de fermeture d'au moins une cavité pour au moins un dispositif microélectronique qui soit compatible avec une fermeture collective de plusieurs cavités, par exemple pour la réalisation d'une encapsulation collective de plusieurs dispositifs microélectroniques à coût réduit, et ne présentant pas les inconvénients de l'art antérieur.

Pour cela, la présente invention propose un procédé de fermeture d'au moins une cavité pour au moins un dispositif microélectronique, comportant au moins les étapes suivantes :
a) réalisation d'au moins une cavité dans un premier substrat comportant au moins une première couche traversée par au moins une ouverture formant un accès à la cavité,
b) réalisation d'au moins une portion de matériau d'accroche autour de l'ouverture, sur ou contre une face de la première couche se trouvant du côté opposé à la cavité,
c) réalisation, sur un second substrat, d'au moins une portion de matériau fusible, par exemple par un dépôt du matériau fusible sur le second substrat et l'utilisation d'un masque,
d) mise en contact de la portion de matériau fusible avec la portion de matériau d'accroche,
e) formation d'un bouchon de l'ouverture, adhérant à la portion de matériau d'accroche par une mise en fusion puis une solidification du matériau fusible,
f) séparation du bouchon et du second substrat.

On entend par dispositif microélectronique un dispositif comportant des éléments de tailles micrométriques ou nanométriques. Ces dispositifs peuvent par exemple être des MEMS ou des NEMS tels que des capteurs de pression, des capteurs inertiels, des résonateurs, etc.

De plus, le premier et/ou le second substrat peuvent être des structures homogènes ou hétérogènes, formé d'une ou plusieurs couches (empilement) de matériaux similaires ou différents.

Le premier substrat peut être un assemblage de plusieurs couches et comportant par exemple des dispositifs microélectroniques disposés dans la cavité et éventuellement un capot ou une membrane au-dessus de la cavité.

Ce procédé peut par exemple s'appliquer pour réaliser une encapsulation d'un ou plusieurs dispositifs microélectroniques disposés dans une ou plusieurs cavités qui sont destinées à être fermées par le procédé selon l'invention. Le procédé peut également d'appliquer à la fermeture d'une ou plusieurs cavités faisant partie d'un ou plusieurs dispositifs microélectroniques, par exemple un dispositif comportant une membrane formant une paroi de la cavité.

Lorsque le premier substrat comporte un capot, le premier substrat peut présenter une structuration formant ainsi au moins une partie de la cavité.

Le procédé selon l'invention est particulièrement intéressant pour la mise en oeuvre d'une fermeture collective de plusieurs cavités.

De plus, ce procédé est très intéressant techniquement et économiquement en raison des avantages suivants :
- grâce à l'utilisation du second substrat comportant la ou les portions de matériau fusible, ce procédé peut réaliser la fermeture collective d'une ou plusieurs cavités dans lesquelles se trouvent plusieurs dispositifs microélectroniques réalisés de manière collective, avant la découpe du premier substrat,
- ce procédé consomme peu de surface sur la première couche qui peut former un capot de la cavité, et est donc compatible avec une réduction croissante de la taille des dispositifs microélectroniques,

- le procédé est compatible avec un contrôle de la pression à l'intérieur de la cavité au moment du scellement, c'est-à-dire de la fermeture de la ou des ouvertures formées dans la première couche,
- le procédé est capable de garantir une très bonne herméticité pendant très longtemps (20 ans et plus) dans des environnements sévères de température et d'humidité grâce à la soudure du ou des bouchons sur la première couche,
- le procédé génère peu de contraintes parasites sur le dispositif microélectronique et est non limitant pour la conception du dispositif lui-même,
- le procédé est compatible avec des étapes réalisées à basses températures, par exemple inférieures à environ 400°C, et peut donc être mis en oeuvre lorsqu'un ou plusieurs circuits électroniques intégrés, par exemple de type CMOS, sont présents sur le ou les dispositifs microélectroniques,
- le ou les bouchons réalisés ne forment pas des surépaisseurs importantes, ce qui réduit l'encombrement du ou des dispositifs microélectroniques encapsulés,
- le procédé est compatible avec l'utilisation de matériau de scellement métallique à très faible dégazage et très haute étanchéité, notamment lorsqu'un vide poussé doit être réalisé dans la cavité,
- le procédé n'implique pas de phase liquide sur le dispositif microélectronique déjà usiné et libéré,
- le procédé est compatible avec toutes formes d'ouvertures réalisées dans la première couche, par exemple des trous ou des tranchées, notamment grâce au fait que le matériau fusible est formé sur le second substrat par l'intermédiaire d'un masque, qui peut être un masque de dépôt ou un masque de gravure, dans lequel une ou plusieurs ouvertures de n'importe quel motif peuvent être réalisées,
- le procédé offre la possibilité d'avoir un dégazage prolongé avant une fermeture rapide de la cavité,
- le procédé est également compatible avec la réalisation de cavités à pressions différentes, par exemple lorsque des accéléromètres devant fonctionner à la pression atmosphérique et des gyromètres devant fonctionner sous vide cohabitent sur un même substrat.

De plus, le second substrat peut ensuite être réutilisé pour effectuer un nouvel assemblage ou la mise en oeuvre d'un autre procédé de fermeture de cavités.

De plus, étant donné que le matériau fusible est déposé sur le second substrat avant de former le bouchon, le matériau fusible peut donc adhérer au second substrat, ce qui permet de réaliser la mise en contact de la portion de matériau fusible avec la portion de matériau d'accroche en disposant le premier substrat au-dessus ou en-dessous du second substrat.

On entend par matériau d'accroche un matériau sur lequel le matériau fusible, lorsqu'il est en fusion, est mouillable, c'est-à-dire sur lequel le matériau fusible s'étale et s'accroche lorsque celui-ci est en fusion. Cette accroche se retrouve également lorsque le matériau fusible refroidi pour redevenir solide, le matériau d'accroche formant alors une surface à laquelle le matériau fusible est soudé.

De plus, en utilisant un matériau fusible entre l'ouverture à fermer et le second substrat, ce procédé permet de réaliser un auto-alignement de cette ouverture avec ledit matériau fusible lors de la mise en oeuvre de l'étape e) de formation du bouchon, en raison notamment des forces de capillarité apparaissant lorsque le matériau fusible est en fusion. On réalise également un auto-alignement du second substrat avec le premier substrat durant le scellement de la cavité.

Ce procédé s'applique par exemple à une encapsulation sur structure immobilisée, le ou les dispositifs microélectroniques n'étant pas encore libérés lorsque le capot, formé au moins en partie par la première couche, est formé sur les dispositifs. Dans ce cas, l'ouverture formée dans le capot peut être utilisée pour graver le matériau immobilisant les dispositifs microélectroniques. Toutefois, ce procédé s'applique également à une encapsulation sur structure libérée, la libération du ou des dispositifs microélectroniques étant réalisées préalablement au scellement du capot.

Le matériau d'accroche peut être un alliage à base de titane, d'or et de nickel, ou un alliage à base de titane, d'or et de palladium, ou un alliage à base de titane, d'or et de platine, et/ou le matériau fusible peut être à base d'étain et/ou d'or et/ou d'indium et/ou de nickel.

Le dispositif microélectronique peut être de type MEMS.

La première couche peut être une couche électriquement isolante disposée sur ou contre une couche semi-conductrice formant également une partie du premier substrat, l'ouverture traversant en outre la couche semi-conductrice.

L'ouverture peut être un trou ou une tranchée, par exemple de forme géométrique plus ou moins complexe.

Le procédé peut comporter en outre, avant l'étape c) de réalisation de la portion de matériau fusible sur le second substrat, une étape de réalisation d'une seconde portion de matériau d'accroche contre le second substrat, la portion de matériau fusible étant ensuite réalisée sur le second substrat en recouvrant la seconde portion de matériau d'accroche.

L'étape c) de réalisation de la portion de matériau fusible peut être obtenue par la mise en oeuvre des étapes suivantes :
- dépôt d'une sous-couche à base d'au moins un matériau électriquement conducteur recouvrant la seconde portion de matériau d'accroche et le second substrat,
- réalisation, sur la sous-couche, du masque comportant au moins une ouverture formant un emplacement pour la portion de matériau fusible,
- dépôt par électrolyse du matériau fusible dans l'ouverture du masque, contre la sous-couche,
- retrait du masque et des portions de la sous-couche non recouvertes par la portion de matériau fusible.

Le matériau électriquement conducteur de la sous-couche peut être un matériau fusible, et par exemple de nature similaire au matériau fusible déposé par électrolyse, permettant ainsi d'obtenir un bouchon homogène formé par la fusion de la portion de matériau fusible et le matériau de la sous-couche.

Dans une variante, l'étape c) de réalisation de la portion de matériau fusible peut être obtenue par la mise en oeuvre des étapes suivantes :
- réalisation, sur le second substrat, du masque comportant au moins une ouverture formant un emplacement pour la portion de matériau fusible,
- dépôt du matériau fusible dans l'ouverture du masque,
- retrait du masque.

L'étape c) de réalisation de la portion de matériau fusible peut être obtenue par la mise en oeuvre des étapes suivantes :
- dépôt, sur le second substrat, d'une couche de matériau fusible,
- réalisation du masque sur la couche de matériau fusible,
- gravure de la couche de matériau fusible selon un motif du masque, formant la portion de matériau fusible,
- retrait du masque.

Le dépôt de matériau fusible peut être un dépôt par évaporation ou par pulvérisation, par exemple mis en oeuvre sous vide.

Le second substrat peut comporter un support disposé contre une couche à base d'un matériau pouvant être gravé sélectivement par rapport au matériau du support.

L'étape f) de séparation du bouchon et du second substrat peut être réalisée par une étape de gravure de la seconde couche.

L'étape f) de séparation du bouchon et du second substrat peut être réalisée par un arrachement du second substrat du bouchon, et éventuellement avant une solidification complète du bouchon (la solidification du matériau fusible réalisée à l'étape e) n'étant dans ce cas que partielle).

Avant l'étape d) de mise en contact de la portion de matériau fusible avec la portion de matériau d'accroche, le premier et le second substrat peuvent être disposés dans un environnement contrôlé en pression et/ou sous atmosphère gazeuse contrôlée.

La surface de la portion de matériau fusible et la surface de la portion de matériau d'accroche destinées à être mises en contact l'une avec l'autre lors de l'étape d) peuvent être sensiblement égales l'une par rapport à l'autre.

Un cycle comprenant la mise en oeuvre des étapes b) à f) peut être répété plusieurs fois, réalisant plusieurs bouchages successifs d'ouvertures différentes traversant la première couche, et dans lequel, pour chaque cycle, avant l'étape d) de mise en contact, le premier et le second substrat peuvent être disposés dans un environnement contrôlé en pression et/ou sous atmosphère gazeuse contrôlée différents pour chaque cycle, et dans lequel la température de fusion du matériau fusible utilisé lors d'un cycle peut être inférieure à la température de fusion du ou des matériaux fusibles utilisés lors du ou des cycles précédents.

L'invention concerne également un procédé d'encapsulation d'au moins un dispositif microélectronique disposé dans une cavité, comportant la mise en oeuvre d'un procédé de fermeture d'au moins une cavité tel que décrit ci-dessus.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A, 1B et 2 à 9 représentent des étapes d'un procédé de fermeture d'une cavité, objet de la présente invention, selon un mode de réalisation particulier,
- la figure 10 représente différentes formes de bouchons pouvant être obtenues lors de la mise en oeuvre d'un procédé de fermeture d'une cavité, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

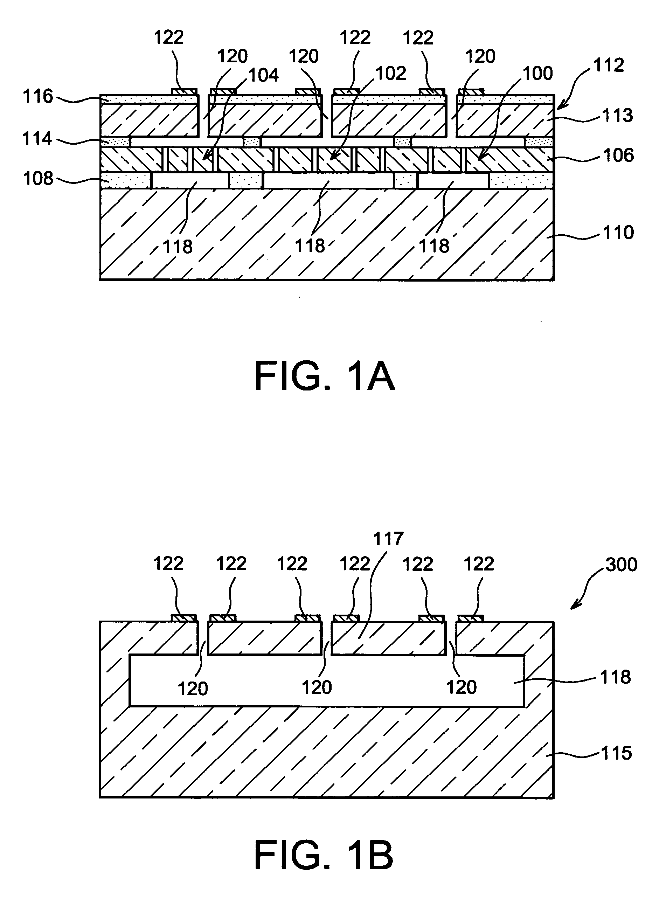

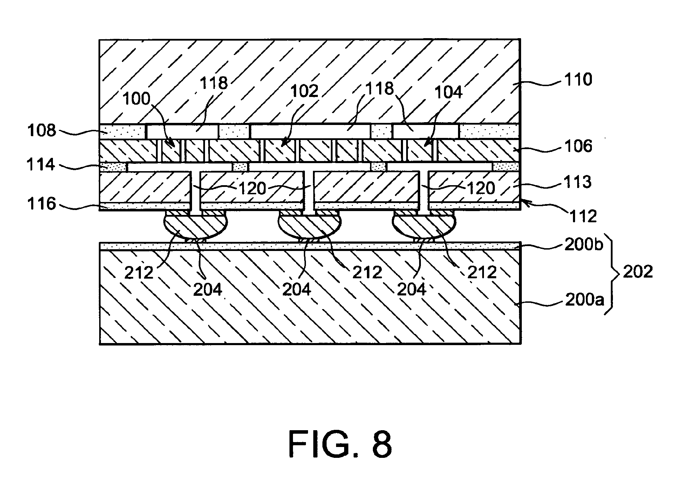

On se réfère aux figures 1A et 2 à 9 qui représentent des étapes d'un procédé d'encapsulation de plusieurs dispositifs microélectroniques 100, 102 et 104, ici de type MEMS, selon un mode de réalisation particulier. Ces dispositifs sont par exemple des accéléromètres, des gyromètres, des commutateurs RF, des résonateurs, ou tout autre dispositif devant être encapsulé pour fonctionner.

Comme représenté sur la figure 1A, ces trois dispositifs MEMS 100, 102 et 104 sont réalisés dans une couche superficielle 106, par exemple à base de silicium, d'un premier substrat comportant également une couche diélectrique 108, par exemple à base de SiO₂, disposée entre la couche superficielle 106 et une couche support 110, également à base de silicium.

Les dispositifs 100, 102 et 104 sont protégés par un capot 112, faisant partie du premier substrat et formé notamment d'une couche 113 à base de semi-conducteur tel que du silicium, disposée au-dessus des dispositifs 100, 102 et 104 et reliée à la couche superficielle 106 par l'intermédiaire d'une couche d'interface 114, par exemple à base d'un diélectrique qui peut être similaire au matériau de la couche diélectrique 108. De manière avantageuse, le capot 112 comporte également une couche électriquement isolante 116 formée contre la face de la couche 113 opposée à celle en contact avec la couche d'interface 114. Chacun des dispositifs 100, 102 et 104 est donc disposé dans une cavité 118 fermée par le capot 112. L'ensemble ainsi formé, représenté sur la figure 1A, constitue un premier substrat.

Une telle structure peut par exemple être obtenue en réalisant tout d'abord les dispositifs 100, 102 et 104, à partir d'un substrat SOI formé par les couches 106, 108 et 110, par des étapes de photolithographie et de gravure dans la couche superficielle 106. La couche d'interface 114 est ensuite déposée sur la couche superficielle 106, y compris sur les dispositifs 100, 102 et 104. La couche 113 est ensuite déposée sur la couche d'interface 114, puis la couche isolante 116 est déposée sur la couche 113. Des ouvertures 120 sont ensuite réalisées à travers la couche isolante 116 et la couche 113, au niveau de chacun des dispositifs 100, 102 et 104, afin d'accéder à la couche d'interface 114. On réalise ensuite une gravure sélective du matériau de la couche d'interface 114 et de la couche diélectrique 108, formant ainsi les cavités 118 autour de chaque dispositif 100, 102 et 104.

Dans l'exemple décrit ici, les ouvertures 120 ont une forme sensiblement cylindrique traversant le capot 112. Toutefois, la forme des ouvertures 120 est adaptée en fonction de la forme et des dimensions des cavités à réaliser, et donc de la forme et des dimensions des dispositifs 100, 102 et 104. Ces ouvertures 120 peuvent donc être par exemple des tranchées réalisées à travers le capot 112, permettant ainsi de mettre à nue une surface plus importante de la couche d'interface 114.

Il s'agit maintenant de réaliser le bouchage des ouvertures 120 afin de fermer les cavités 118. Pour cela, on réalise tout d'abord des portions 122 d'un matériau d'accroche autour des ouvertures 120 en déposant une couche à base de ce matériau d'accroche sur la couche isolante 116 puis en gravant cette couche pour former les portions 122 de ce matériau d'accroche. Il est également possible de réaliser le dépôt et la gravure de cette couche de matériau d'accroche après le dépôt de la couche isolante 116 mais avant la réalisation des ouvertures 120. Dans l'exemple décrit ici, le matériau d'accroche utilisé est un alliage à base de titane, d'or et de nickel, ou un alliage à base de titane, d'or et de palladium, ou encore un alliage à base de titane, d'or et de platine. Ces alliages présentent notamment de bonnes propriétés de mouillabilité et d'accroche vis-à-vis du matériau fusible qui sera utilisé dans la suite du procédé.

Dans l'exemple représenté sur la figure 1A, on réalise une encapsulation des dispositifs 100, 102 et 104 qui sont disposés dans les cavités 118 formées dans le premier substrat.

Dans une variante, le procédé de fermeture de cavité décrit ici peut s'appliquer à la fermeture d'une cavité faisant partie d'un dispositif microélectronique. Comme représenté sur la figure 1B, un dispositif 300, ici un capteur de pression, est formé dans un premier substrat 115 comprenant une couche 117. Une cavité 118 est réalisée dans la couche 115, la paroi supérieure de la cavité 118 étant formée par la couche 117 qui joue ici le rôle d'une membrane sensible à la pression. Une ouverture 120 traverse la couche 117 et forme un accès à la cavité 118. Comme décrit sur l'exemple de la figure 1A, les portions 122 d'un matériau d'accroche sont formées autour de l'ouverture 120.

On décrit maintenant la suite du procédé pour réaliser le bouchage des cavités 118 représentées sur la figure 1A. Toutefois, la fermeture de la cavité 118 du dispositif 300 peut être réalisée de manière similaire.

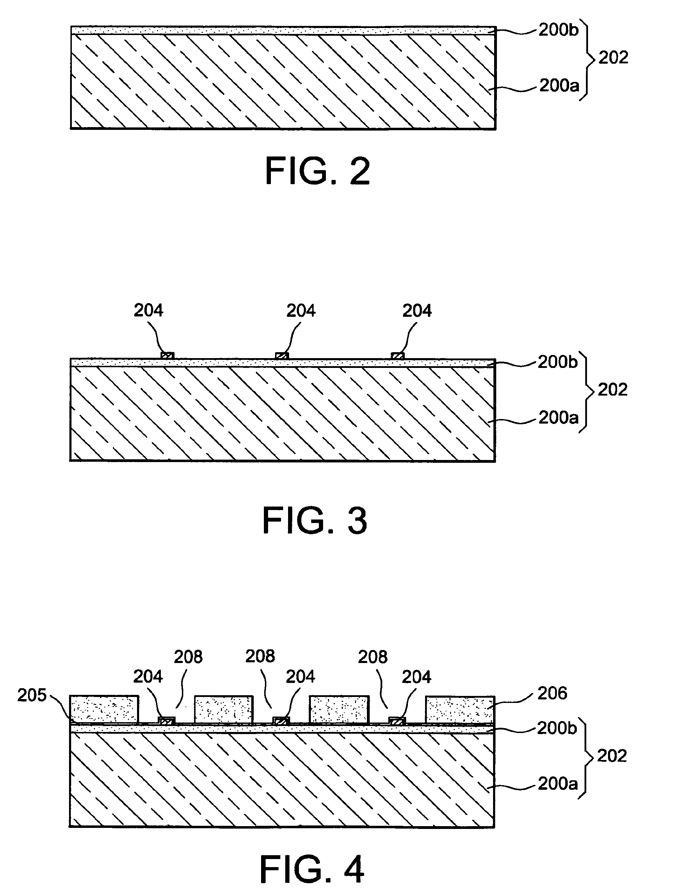

Parallèlement à la réalisation de la structure précédemment décrite en liaison avec la figure 1A (ou celle représentée sur la figure 1B), on réalise une seconde structure qui sera utilisée pour réaliser le bouchage des ouvertures 120. Comme représenté sur la figure 2, on réalise, par exemple par un dépôt, une couche sacrificielle 200b, par exemple à base de SiO₂ ou de titane, sur un support 200a par exemple à base de semi-conducteur, ici du silicium. La couche sacrificielle 200b et le support 200a forment un second substrat désigné par la référence 202.

On dépose ensuite, sur la couche sacrificielle 200b, une couche d'accroche, par exemple à base d'un matériau identique à celui utilisé pour former les portions d'accroche 122. Cette couche d'accroche est ensuite gravée pour ne laisser subsister que des portions 204 de cette couche d'accroche au niveau d'emplacements destinés à recevoir des portions de matériau fusible qui seront utilisées pour réaliser le bouchage des ouvertures 120 (voir figure 3).

Une sous-couche d'électrolyse 205 est ensuite déposée sur la structure réalisée, c'est-à-dire recouvrant les portions d'accroche 204 et la couche sacrificielle 200b. Cette sous-couche d'électrolyse 205 est à base d'un matériau électriquement conducteur, et de préférence à base d'un matériau fusible similaire à celui destiné à être utilisé pour former les portions de matériau fusible qui seront utilisées pour boucher les ouvertures 120. On dépose ensuite une couche de masque 206 sur la sous-couche d'électrolyse 205. Cette couche de masque 206 est ensuite photolithographiée et gravée afin de former des emplacements 208, au niveau des portions d'accroche 204, au niveau desquels les portions de matériau fusible sont destinées à être réalisées (figure 4).

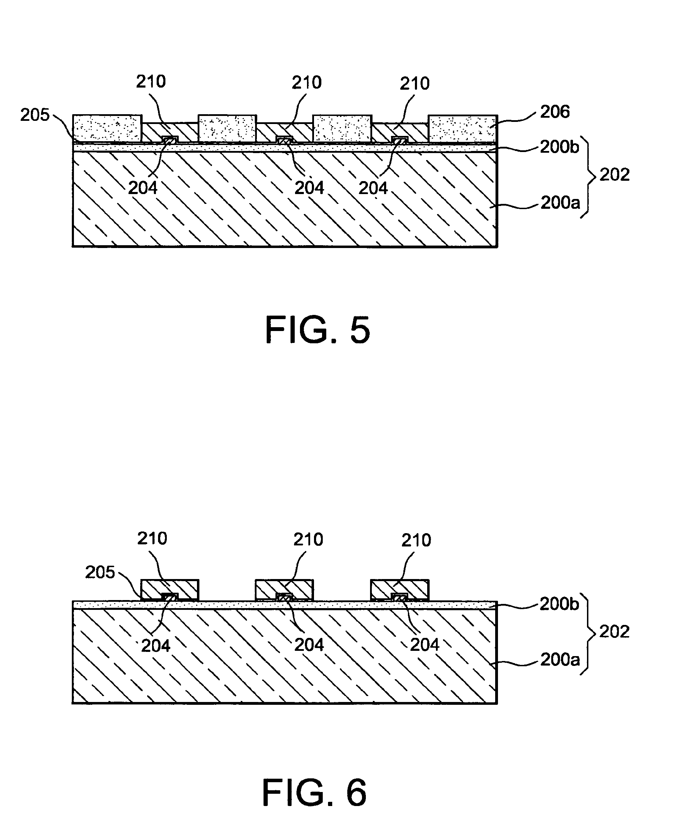

Comme représenté sur la figure 5, on réalise ensuite par électrolyse des portions de matériau fusible 210, à base du matériau de la sous-couche 205, dans les ouvertures 208, sur la sous-couche d'électrolyse 205. Ce matériau fusible est similaire au matériau de la sous-couche d'électrolyse 205.

La forme et les dimensions des emplacements 208 sont choisies en fonction de la forme et des dimensions des portions de matériau fusible 210 que l'on souhaite obtenir, et donc en fonction de la forme et des dimensions des ouvertures 120 que l'on souhaite boucher. Dans le mode de réalisation décrit ici, les dimensions des portions de matériau d'accroche 204 sont bien inférieures à celles des portions de matériau fusible 210.

Enfin, comme représenté sur la figure 6, la couche de masque 206 est retirée et la sous-couche d'électrolyse 205 encore présente entre les portions 210 de matériau fusible est supprimée, par exemple par gravure.

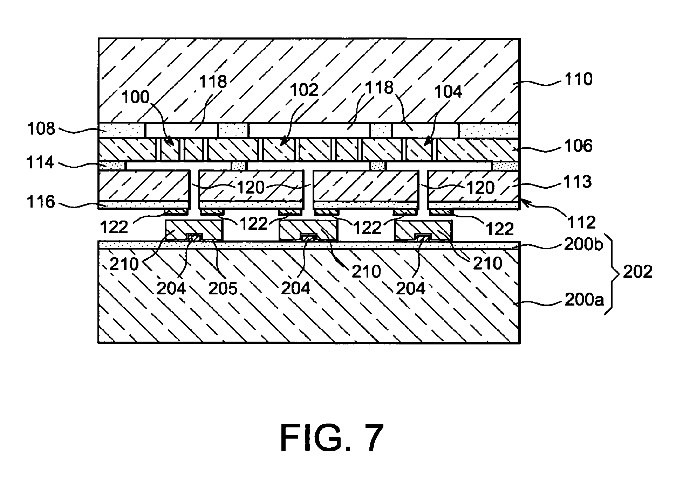

Le premier substrat comportant les dispositifs 100, 102 et 104 est alors retourné afin que les ouvertures 120 soient mises en regard et alignées avec les portions 210 de matériau fusible (voir figure 7).

Dans le cas où les dispositifs 100, 102 et 104 sont destinés à fonctionner dans un environnement particulier (sous vide ou sous atmosphère d'un gaz particulier), on réalise alors une mise sous vide, ou un mise sous atmosphère gazeuse des deux substrats en regard l'un de l'autre afin que cet environnement particulier se retrouve dans les cavités 118.

On met alors en contact les portions de matériau fusible 210 et les portions d'accroche 122, puis le matériau fusible 210, ainsi que les portions de la sous-couche d'électrolyse 205 se trouvant sous les portions de matériau fusible 210, sont mis en fusion, par exemple par un chauffage. Les portions de matériau fusible 210 et de la sous-couche d'électrolyse 205 en fusion mouillent alors les portions d'accroche 122 et 204, et forment des bouchons 212 fermant les cavités 118. Un auto-alignement des bouchons 212 vis-à-vis des ouvertures 120 est réalisé automatiquement grâce aux forces de capillarité apparaissant lors de la mise en fusion du matériau fusible, entre ce matériau fusible et les portions d'accroche 122. La température est ensuite abaissée jusqu'à obtenir une solidification des bouchons 212.

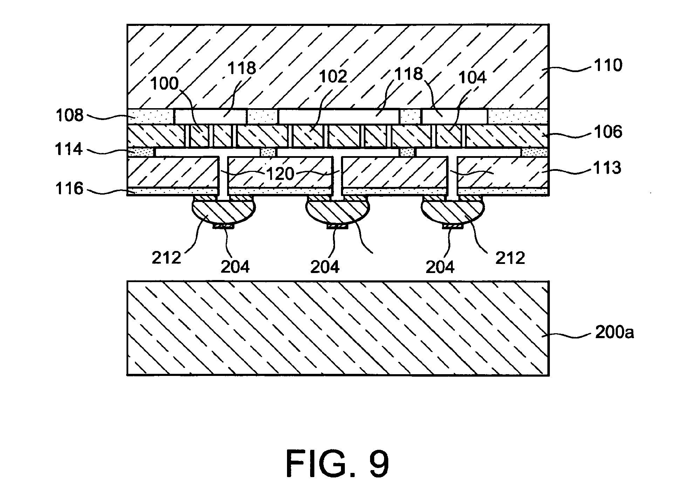

On réalise alors une séparation du support 200a et des bouchons 212 en gravant la couche sacrificielle 200b (figure 9). Les portions d'accroche 204 restent ici solidaires des bouchons 212.

Le choix du ou des matériaux pour réaliser les portions de matériau fusible 210 (et donc également de la sous-couche d'électrolyse 205) ainsi que les portions 122 de matériau d'accroche est réalisé notamment en fonction des températures que les dispositifs 100, 102 et 104 peuvent tolérer lors de la mise en fusion de ces matériaux. Par exemple, le matériau fusible peut être à base d'indium (température de fusion égale à environ 156°C) dans le cas où les dispositifs 100, 102 et 104 ne tolèrent que des très basses températures, à base d'un alliage d'or et d'étain (température de fusion égale à environ 260°C) dans le cas où les dispositifs 100, 102 et 104 tolèrent des températures moyennes, ou encore à base d'un alliage de nickel et d'étain (température de fusion égale à environ 300°C) lorsque les dispositifs 100, 102 et 104 tolèrent des températures plus importantes.

Dans une variante, il est possible de réaliser un bouchage des cavités 118 à des pressions ou des environnements gazeux différents, par exemple pour deux types de dispositifs différents. Pour cela, les étapes précédemment décrites en liaison avec les figures 2 à 9 sont répétées plusieurs fois en bouchant à chaque fois des cavités différentes dans des environnements gazeux ou sous des pressions différentes. Le matériau fusible utilisé pour chaque cycle des étapes de bouchage est dans ce cas choisi avec une température de fusion plus basse que le matériau fusible utilisé aux étapes de bouchage précédentes afin de ne pas faire fondre les bouchons réalisés lors des étapes de bouchage précédentes. Pour cela, les matériaux fusibles utilisés au cours des différents cycles peuvent être à base d'alliages différents présentant des températures de fusion différentes, ces différences présentant par exemple quelques dizaines de degrés de différence. Il est par exemple possible d'utiliser, lors du bouchage d'une première série d'ouvertures, un premier alliage à base de 95,5% d'étain, de 3,5% d'aluminium et de 1% de cuivre. La température de fusion d'un tel alliage est comprise entre environ 235°C et 245°C. Lors du bouchage de secondes ouvertures, un second alliage à base de 63% d'étain et de 37% de plomb, présentant une température de fusion comprise entre environ 215°C et 225°C pourra être utilisé.

Dans l'exemple précédemment décrit, la couche sacrificielle 200b est utilisée pour désolidariser les bouchons 212 du support 200a en gravant cette couche sacrificielle 200b. Toutefois, dans une variante, il est possible que la couche sacrificielle 200b ne soit pas gravée, mais que celle-ci soit arrachée des bouchons 212, de préférence juste avant la solidification totale des bouchons 212 car à ce moment, les forces de liaisons entre les portions d'accroche 204 et le matériau fusible sont encore faibles, bien que le bouchon soit près de l'état solide. Dans ce cas, les portions d'accroche 204 ne restent pas collées aux bouchons solidifiés 212 après la séparation de la couche 202 de ces bouchons 212.

Dans une variante, il est possible que les portions de matériau fusible 210 ne soit pas réalisées par électrolyse sur le second substrat 202, mais par un dépôt, par exemple un dépôt sous vide par évaporation ou pulvérisation cathodique, permettant d'obtenir également une adhérence des portions de matériau fusible 210 au second substrat 202. Dans cette variante, on ne réalise donc pas de dépôt de la sous-couche d'électrolyse 205, le masque 206 et les portions de matériau fusible 210 étant directement déposés sur le second substrat 202, par exemple sur la couche sacrificielle 200b et/ou les portions de couche d'accroche 204.

Dans une autre variante de réalisation, il est possible que les portions de matériau fusible ne soient pas réalisées par l'intermédiaire d'un masque de dépôt, mais par l'intermédiaire d'un masque de gravure. Dans ce cas, le matériau fusible est tout d'abord déposé, par exemple par évaporation ou par pulvérisation, sous la forme d'une couche pleine plaque sur le second substrat. Un masque de lithographie est ensuite réalisé sur la couche de matériau fusible, cette couche de matériau fusible étant ensuite gravée selon le motif du masque afin de former les portions de matériau fusible.

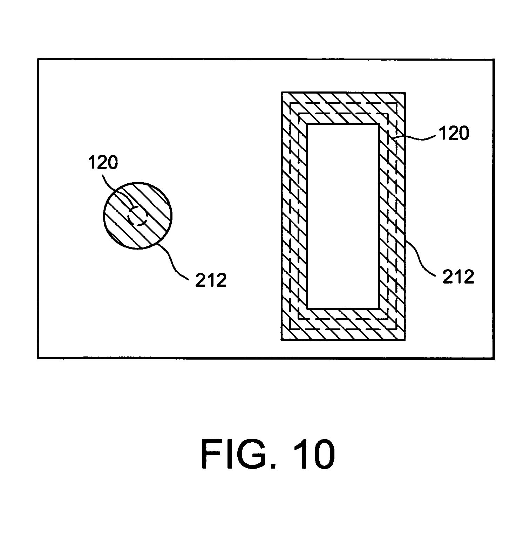

Quelque soit la variante de réalisation, le procédé de fermeture de cavité décrit ici permet de fermer des ouvertures de n'importe quelle forme. Deux exemples d'ouvertures 120 sont représentées sur la figure 10 : l'une (à gauche) étant un trou de forme circulaire, l'autre (à droite) étant une tranchée fermée de forme rectangulaire. On voit que ces ouvertures 120 sont chacune fermées par un bouchon 212 de forme adaptée à la forme de l'ouverture 120. La forme du bouchon 212 correspond à la forme de l'ouverture réalisée à travers le masque qui est utilisé pour déposer le matériau fusible sur le second substrat ou pour graver le matériau fusible.

## Revendications

1. Procédé de fermeture d'au moins une cavité (118) pour au moins un dispositif microélectronique (100, 102, 104, 300), comportant au moins les étapes suivantes :
a) réalisation d'au moins une cavité (118) dans un premier substrat (115) comportant au moins une première couche (116, 117) traversée par au moins une ouverture (120) formant un accès à la cavité (118),
b) réalisation d'au moins une portion de matériau d'accroche (122) autour de l'ouverture (120), sur une face de la première couche (116, 117) se trouvant du côté opposé à la cavité (118),
c) réalisation, sur un second substrat (202), d'au moins une portion de matériau fusible (210) par un dépôt du matériau fusible (210) sur le second substrat (202) et l'utilisation d'un masque (206),
d) mise en contact de la portion de matériau fusible (210) avec la portion de matériau d'accroche (122),
e) formation d'un bouchon (212) de l'ouverture (120), adhérant à la portion de matériau d'accroche (122) par une mise en fusion puis une solidification du matériau fusible (210),
f) séparation du bouchon (212) et du second substrat (202).

2. Procédé selon la revendication 1, dans lequel le matériau d'accroche est un alliage à base de titane, d'or et de nickel, ou un alliage à base de titane, d'or et de palladium, ou un alliage à base de titane, d'or et de platine, et/ou le matériau fusible est à base d'étain et/ou d'or et/ou d'indium et/ou de nickel.

3. Procédé selon l'une des revendications précédentes, dans lequel le dispositif microélectronique (100, 102, 104, 300) est de type MEMS.

4. Procédé selon l'une des revendications précédentes, dans lequel la première couche (116) est une couche électriquement isolante disposée sur une couche semi-conductrice (113) formant également une partie du premier substrat, l'ouverture (120) traversant en outre la couche semi-conductrice (113).

5. Procédé selon l'une des revendications précédentes, dans lequel l'ouverture (120) est un trou ou une tranchée.

6. Procédé selon l'une des revendications précédentes, comportant en outre, avant l'étape c) de réalisation de la portion de matériau fusible (210) sur le second substrat (202), une étape de réalisation d'une seconde portion de matériau d'accroche (204) contre le second substrat (202), la portion de matériau fusible (210) étant ensuite réalisée sur le second substrat (202) en recouvrant la seconde portion de matériau d'accroche (204).

7. Procédé selon la revendication 6, dans lequel l'étape c) de réalisation de la portion de matériau fusible (210) est obtenue par la mise en oeuvre des étapes suivantes :
- dépôt d'une sous-couche (205) à base d'au moins un matériau électriquement conducteur recouvrant la seconde portion de matériau d'accroche (204) et le second substrat (202),
- réalisation, sur la sous-couche (205), du masque (206) comportant au moins une ouverture (208) formant un emplacement pour la portion de matériau fusible (210),
- dépôt par électrolyse du matériau fusible (210) dans l'ouverture (208) du masque (206), contre la sous-couche (205),
- retrait du masque (206) et des portions de la sous-couche (205) non recouvertes par la portion de matériau fusible (210).

8. Procédé selon la revendication 7, dans lequel le matériau électriquement conducteur de la sous-couche (205) est un matériau fusible.

9. Procédé selon la revendication 8, dans lequel le matériau fusible de la sous-couche (205) est de nature similaire au matériau fusible (210) déposé par électrolyse.

10. Procédé selon l'une des revendications 1 à 6, dans lequel l'étape c) de réalisation de la portion de matériau fusible (210) est obtenue par la mise en oeuvre des étapes suivantes :
- réalisation, sur le second substrat (202), du masque (206) comportant au moins une ouverture (208) formant un emplacement pour la portion de matériau fusible (210),
- dépôt du matériau fusible (210) dans l'ouverture (208) du masque (206),
- retrait du masque (206).

11. Procédé selon l'une des revendications 1 à 6, dans lequel l'étape c) de réalisation de la portion de matériau fusible (210) est obtenue par la mise en oeuvre des étapes suivantes :
- dépôt, sur le second substrat (202), d'une couche de matériau fusible,
- réalisation du masque sur la couche de matériau fusible,
- gravure de la couche de matériau fusible selon un motif du masque, formant la portion de matériau fusible (210),
- retrait du masque.

12. Procédé selon l'une des revendications 10 ou 11, dans lequel le dépôt de matériau fusible est un dépôt par évaporation ou par pulvérisation.

13. Procédé selon l'une des revendications précédentes, dans lequel le second substrat (202) comporte un support (200a) disposé contre une seconde couche (200b) à base d'un matériau pouvant être gravé sélectivement par rapport au matériau du support (200a).

14. Procédé selon la revendication 13, dans lequel l'étape f) de séparation du bouchon (212) et du second substrat (202) est réalisée par une étape de gravure de la seconde couche (200b).

15. Procédé selon l'une des revendications 1 à 13, dans lequel l'étape f) de séparation du bouchon (212) et du second substrat(202) est réalisée par un arrachement du second substrat (202) du bouchon (212).

16. Procédé selon l'une des revendications précédentes, dans lequel, avant l'étape d) de mise en contact de la portion de matériau fusible (210) avec la portion de matériau d'accroche (122), le premier substrat et le second substrat (202) sont disposés dans un environnement contrôlé en pression et/ou sous atmosphère gazeuse contrôlée.

17. Procédé selon l'une des revendications précédentes, dans lequel la surface de la portion de matériau fusible (210) et la surface de la portion de matériau d'accroche (122) destinées à être mises en contact l'une avec l'autre lors de l'étape d) étant sensiblement égales l'une par rapport à l'autre.

18. Procédé selon l'une des revendications précédentes, dans lequel un cycle comprenant la mise en oeuvre des étapes b) à f) est répété plusieurs fois, réalisant plusieurs bouchages successifs d'ouvertures (120) différentes traversant la première couche (116), et dans lequel, pour chaque cycle, avant l'étape d) de mise en contact, le premier et le second substrat (202) sont disposés dans un environnement contrôlé en pression et/ou sous atmosphère gazeuse contrôlée différent pour chaque cycle, et dans lequel la température de fusion du matériau fusible utilisé lors d'un cycle est inférieure à la température de fusion du ou des matériaux fusibles utilisés lors du ou des cycles précédents.

19. Procédé d'encapsulation d'au moins un dispositif microélectronique (100, 102, 104) disposé dans une cavité (118), comportant la mise en oeuvre d'un procédé de fermeture d'au moins une cavité (118) selon l'une des revendications précédentes.

## Claims

1. Process for closing at least one cavity (118) for at least one microelectronic device (100, 102, 104, 300), comprising at least the following steps:
a) Producing at least one cavity (118) in a first substrate (115) comprising at least one first layer (116, 117) traversed by at least one opening (120) forming an access to the cavity (118);
b) Producing at least one portion of bond material (122) around the opening (120), on a face of the first layer (116, 117) located on the side opposite the cavity (118);
c) Producing, on a second substrate (202), at least one portion of fusible material (210) with a deposition of the fusible material (210) on the second substrate (202) and the use of a mask (206);
d) Placing the portion of fusible material (210) in contact with the portion of bond material (122);
e) Forming a plug (212) for the opening (120), which adheres to the portion of bond material (122), by melting and then solidification of the fusible material (210);
f) Separating the plug (212) and the second substrate (202).

2. Process according to claim 1, in which the bond material is a titanium, gold and nickel-based alloy, or a titanium, gold and palladium-based alloy, or a titanium, gold and platinum-based alloy, and / or the fusible material is tin and / or gold and / or indium and / or nickel-based.

3. Process according to any one of the preceding claims, in which the microelectronic device (100, 102, 104, 300) is MEMS type.

4. Process according to any one of the preceding claims, in which the first layer (116) is an electrically insulating layer placed over a semiconducting layer (113) also forming a part of the first substrate, with the opening (120) additionally traversing the semiconducting layer (113).

5. Process according to any one of the preceding claims, in which the opening (120) is a hole or trench.

6. Process according to any one of the preceding claims, comprising additionally, before step c) producing the fusible material portion (210) on the second substrate (202), a step implementing a second portion of bond material (204) against the second substrate (202), the portion of fusible material (210) next being made on the second substrate (202) by covering over the second portion of bond material (204).

7. Process according to claim 6, in which step c) producing the fusible material portion (210) is obtained by implementing the following steps:
- Depositing a sublayer (205) based on at least one electrically conducting material covering the second portion of bond material (204) and the second substrate (202);
- Producing, on the sublayer (205), the mask (206) comprising at least one opening (208) forming a location for the fusible material portion (210);
- Depositing the fusible material (210) in the opening (208) of the mask (206), against the sublayer (205), by electrolysis;
- Removing the mask (206) and portions of the sublayer (205) not covered by the fusible material portion (210).

8. Process according to claim 7, in which the electrically conducting material from the sublayer (205) is a fusible material.

9. Process according to claim 8, in which the fusible material from the sublayer (205) is of similar nature to the fusible material (210) deposited by electrolysis.

10. Process according to any one of claims 1 to 6, in which step c) producing the fusible material portion (210) is obtained by implementing the following steps:
- Producing, on the second substrate (202), the mask (206) comprising at least one opening (208) forming a location for the fusible material portion (210);
- Depositing the fusible material (210) in the opening (208) of the mask (206);
- Removing the mask (206).

11. Process according to any one of claims 1 to 6, in which step c) producing the fusible material portion (210) is obtained by implementing the following steps:
- Depositing a layer based on the fusible material, on the second substrate (202);
- Producing the mask on the layer based on the fusible material;
- Etching of the layer based on the fusible material according to a pattern of the mask, forming the fusible material portion (210);
- Removing the mask.

12. Process according to claim 10 or 11, in which the deposition of the fusible material is a deposition by evaporation or cathodic sputtering.

13. Process according to any one of the preceding claims, in which the second substrate (202) comprises a support (200a) placed against a second layer (200b) based on a material which can be selectively etched relative to the support material (200a) .

14. Process according to claim 13, in which the step f) separating the plug (212) and the second substrate (202) is done by a step of etching of the second layer (200b).

15. Process according to any one of claims 1 to 13, in which the step f) separating the plug (212) and the second substrate (202) is done by a step of pulling the second substrate (202) away from the plug (212).

16. Process according to any one of the preceding claims, in which before step d) placing the fusible material portion (210) in contact with the bond material portion (122), the first and second substrate (202) are placed in an environment with controlled pressure and / or under controlled gaseous atmosphere.

17. Process according to any one of the preceding claims, in which the surface area of the fusible material portion (210) and the surface area of the bond material portion (122) intended to be brought into contact with each other during step d) are substantially equal to each other.

18. Process according to any one of the preceding claims, in which a cycle comprising implementation of steps b) to f) is repeated several times, making several successive plugs for various openings (120) traversing the first layer (116), and in which, for each cycle, before the step d) of bringing into contact, the first and second substrate (202) are placed in an environment with controlled pressure and / or under controlled gaseous atmosphere which are different for each cycle, and in which the melting point of the fusible material used during one cycle is less than the melting point of the fusible material(s) used during the previous cycle(s).

19. Process for encapsulating at least one microelectronic device (100, 102, 104) placed in a cavity (118), comprising the implementation of a closure process for at least one cavity (118) according to any one of the preceding claims.

## Patentansprüche

1. Verfahren zum Schießen wenigstens einer Kavität (118) für wenigstens eine mikroelektronische Vorrichtung (100, 102, 104, 300), umfassend wenigstens die folgenden Schritte:
a) Bilden wenigstens einer Kavität (118) in einem ersten Substrat (115), welches wenigstens eine erste Schicht (116, 117) umfasst, die von wenigstens einer Öffnung (120) durchsetzt ist, welche einen Zugang zu der Kavität (118) bildet,
b) Bilden wenigstens eines Abschnitts aus einem Haftmaterial (122) um die Öffnung (120) herum auf einer Seite der ersten Schicht (116, 117), welche sich seitlich gegenüber von der Kavität (118) befindet,
c) Bilden wenigstens eines Abschnitts aus schmelzbarem Material (210) auf einem zweiten Substrat (202) durch eine Ablagerung des schmelzbaren Materials (210) auf dem zweiten Substrat (202) und die Verwendung einer Maske (206),
d) In-Konfiakt-Bringen des Abschnitts schmelzbaren Materials (210) mit dem Haftmaterialabschnitt (122),
e) Bilden eines Stopfens (212) für die Öffnung (120), welcher an dem Haftmaterialabschnitt (122) haftet durch ein Schmelzen und ein anschließendes Verfestigen des schmelzbaren Materials (210),
f) Separation des Stopfens (212) und des zweiten Substrats (202).

2. Verfahren nach Anspruch 1, wobei das Haftmaterial eine Legierung auf Grundlage von Titare, Gold und Nickel ist, oder eine Legierung auf Grundlage von Titan, Gold und Palladium ist, oder eine Legierung auf Grundlage von Titan, Gold und Platin ist, oder/und das schmelzbare Material auf Grundlage von Zinn oder/und von Gold oder/und von Indium oder/und von Nickel gebildet ist.

3. Verfahren nach einem der vorhergehenden Ansprüche, wobei die mikroelektronische Vorrichtung (100, 102, 104, 300) von der MEMS-Art ist.

4. Verfahren nach einem der vorhergehenden Ansprüche, wobei die erste Schicht (116) eine elektrisch isolierende Schicht ist, welche auf einer Halbleiterschicht (113) angeordnet ist, welche auch einen Abschnitt des ersten Substrats bildet, wobei die Öffnung (120) ferner die Halbleiterschicht (113) durchsetzt.

5. Verfahren nach einem der vorhergehenden Ansprüche, wobei die Öffnung (120) ein Loch oder eine Rinne ist.

6. Verfahren nach einem der vorhergehenden Ansprüche, ferner umfassend einen Schritt eines Bildens eines zweiten Abschnitts aus Haftmaterial (204) gegen das zweite Substrat (202) vor dem Schritt c) eines Bildens des Abschnitts schmelzbaren Materials (210) auf dem zweiten Substrat (202), wobei danach der Abschnitt schmelzbaren Materials (210) auf dem zweiten Substrat (202) durch Bedecken des zweiten Abschnitts aus Haftmaterial (204) gebildet wird.

7. Verfahren nach Anspruch 6, wobei der Schritt c) eines Bildens des Abschnitts aus schmelzbarem Material (210) durch Umsetzen der folgenden Schritte erhalten wird:
- Ablagerung einer Unterschicht (205) auf Grundlage wenigstens eines elektrisch leitenden Materials, welches den zweiten Abschnitt aus Haftmaterial (204) und das zweite Substrat (202) bedeckt,
- Bilden der Maske (206) auf der Unterschicht (205), wobei die Maske wenigstens eine Öffnung (208) umfasst, die einen Platz für den Abschnitt schmelzbaren Materials (210) bildet,
- Ablagerung des schmelzbaren Materials (210) in der Öffnung (208) der Maske (206) gegen die Unterschicht (205) durch Elektrolyse,
- Zurückziehen der Maske (206) und der Abschnitt der Unterschicht (205), welche nicht durch den Abschnitt aus schmelzbarem Material (210) bedeckt sind.

8. Verfahren nach Anspruch 7, wobei das elektrisch leitende Material der Unterschicht (205) ein schmelzbares Material ist.

9. Verfahren nach Anspruch 8, wobei das schmelzbare Material der Unterschicht (205) von einer Art ist, welche dem durch Elektrolyse abgelagerte schmelzbaren Material (210) ähnlich ist.

10. Verfahren nach einem der Ansprüche 1 bis 6, wobei der Schritt c) eines Bildens des Abschnitts aus schmelzbarem Material (210) durch Umsetzen der folgenden Schritte erhalten wird:
- Bilden der Maske (206) auf dem zweiten Substrat (202), wobei die Maske wenigstens eine Öffnung (208) umfasst, welche einen Platz für den Abschnitt schmelzbaren Materials (210) bildet,
- Ablagerung des schmelzbaren Materials (210) in der Öffnung (208) der Maske (206),
- Zurückziehen der Maske (206).

11. Verfahren nach einem der Ansprüche 1 bis 6, wobei der Schritt c) eines Bildens des Abschnitts aus schmelzbarem Material (210) durch Umsetzen der folgenden Schritte erhalten wird:
- Ablagerung einer Schicht aus schmelzbarem Material auf dem zweiten Substrat (202),
- Bilden der Maske auf der Schicht schmelzbaren Materials,
- Ätzen der Schicht schmelzbaren Materials gemäß einem Muster der Maske unter Bildung des Abschnitts schmelzbaren Materials (210),
- Zurückziehen der Maske.

12. Verfahren nach einem der Ansprüche 10 oder 11, wobei die Ablagerung von schmelzbarem Material eine Ablagerung durch Verdampfen oder durch Sputtern ist.

13. Verfahren nach einem der vorhergehenden Ansprüche, wobei das zweite Substrat (202) einen Träger (200a) umfasst, welcher gegen eine zweite Schicht (200b) auf Grundlage eines Materials angeordnet ist, welches in Bezug auf des Material des Trägers (200a) selektiv ätzbar ist.

14. Verfahren nach Anspruch 13, wobei der Schritt f) einer Separation des Stopfens (212) und des zweiten Substrats (202) durch einen Schritt eines Ätzens der zweiten Schicht (200b) gebildet ist.

15. Verfahren nach einem der Ansprüche 1 bis 13, wobei der Schritt f) einer Separation des Stopfens (212) und des zweiten Substrats (202) durch ein Ablösen des zweiten Substrats (202) von dem Stopfen (212) gebildet ist.

16. Verfahren nach einem der vorhergehenden Ansprüche, wobei vor dem Schritt d) eines In-Kontakt-Bringens des Abschnitts schmelzbaren Materials (210) mit dem Abschnitt aus Haftmaterial (122) das erste Substrat und das zweite Substrat (202) in einer druckkontrollierten bzw. druckgeregelten/- gesteuerten Umgebung oder/und in einer kontrollierten Gasatmosphäre angeordnet werden.

17. Verfahren nach einem der vorhergehenden Ansprüche, wobei die Fläche des Abschnitts schmelzbaren Materials (210) und die Fläche des Abschnitts aus Haftmaterial (122), welche dazu bestimmt sind, miteinander bei Schritt d) in Kontakt gebracht zu werden, im Wesentlichen einander gleich sind.

18. Verfahren nach einem der vorhergehenden Ansprüche, wobei ein Zyklus, welcher die Umsetzung der Schritte b) bis f) umfasst, mehrere Male wiederholt wird, wobei mehrere sukzessiv Verschlüsse verschiedener Öffnungen (120), welche die erste Schicht (116) durchsetzen, gebildet werden und wobei bei jedem Zyklus vor dem Schritt d) eines In-Kontakt-Bringens das erste und das zweite Substrat (202) in einer druckkontrollierten bzw. druckgeregelten/-gesteuerten Umgebung oder/und in einer kontrollierten Gasatmosphäre angeordnet sind, welche für jeden Zyklus verschieden ist, und wobei die Schmelztemperatur des schmelzbaren Materials, welches bei einem Zyklus verwendet wird, kleiner als die Schmelztemperatur des oder der schmelzbaren, bei dem vorhergehenden Zyklus oder bei den vorhergehenden Zyklen verwendeten Materials bzw. Materialien ist.

19. Verfahren zur Einkapselung wenigstens einer mikroelektronischen Vorrichtung (100, 102, 104), welche in einer Kavität (118) angeordnet ist, umfassend die Umsetzung eines Verfahrens zum Schließen wenigstens einer Kavität (118) nach einem der vorhergehenden Ansprüche.
